# EUROPEAN PATENT SPECIFICATION

(11) **EP 1 611 681 B1**
(45) Date of publication and mention of the grant of the patent: **30.05.2007**
(21) Application number: 04725457.8
(22) Date of filing: 02.04.2004
(51) Int. Cl.: H03K 3/3565

(54) **SCHMITT TRIGGER CIRCUIT IN SOI**
SCHMITT-TRIGGER-SCHALTUNG IN SOI-TECHNIK
CIRCUIT DE BASCULE DE SCHMITT UTILISANT LA TECHNOLOGIE SILICIUM-SUR-ISOLANT

(30) Priority: 02.04.2003 FR 0304088
(43) Date of publication of application: 04.01.2006
(73) Proprietor: SOISIC, 38054 Grenoble (FR)
(72) Inventor: FAVARD, Thierry, F-75010 Paris (FR)
(74) Representative: Robinson, Nigel Alexander Julian
(86) International application number: PCT/IB2004/001402
(87) International publication number: WO 2004/088844

(56) References cited:
- US-A- 5 608 344
- US-B1- 6 239 649
- US-B1- 6 441 663

## Description

This invention relates to a trigger circuit with hysteresis and a CMOS integrated circuit comprising such a trigger with hysteresis.

More precisely, the invention relates to a new inverter circuit with hysteresis, particularly a new Schmitt trigger circuit and a CMOS integrated circuit comprising such an inverter with hysteresis. In particular, the invention proposes an integrated circuit adapted to any CMOS semiconductor on insulator technology. The preferred CMOS semiconductor on insulator technology in this case is the Partially Depleted Silicon On Insulator (PD SOI) technology.

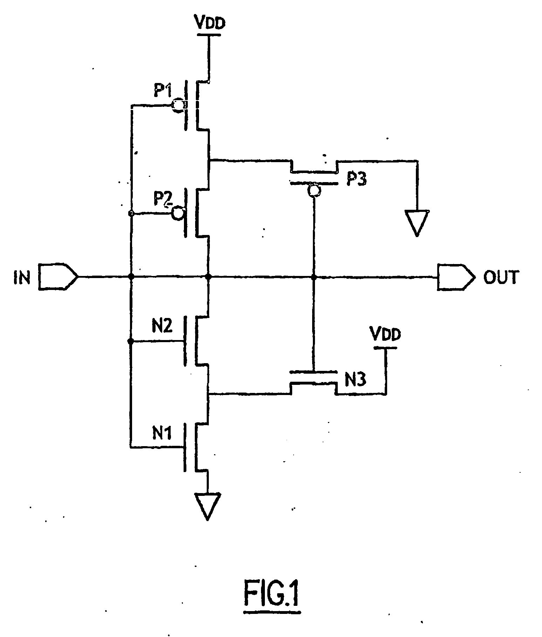

Classically, it has been known how to make a Schmitt electric trigger circuit in CMOS technology. Figure 1 illustrates one of several possible symmetric implementations of such a Schmitt trigger circuit. The circuit in Figure 1 comprises six transistors: transistors N2 and P2 forming the main inverter of the Schmitt trigger, while firstly transistors N1 and N3, and secondly transistors P1 and P3 form two retroaction networks. Each of the said two retroaction networks fixes a trigger threshold and the two thresholds thus obtained consequently induce a hysteresis effect (the hysteresis value being fixed by the voltage difference between these two thresholds). Therefore, the Schmitt trigger is switched over at different values of the said input voltage, depending on the direction of change of the input voltage. Thus, as long as the input voltage V_{IN} has not exceeded the switching threshold V₊, the output signal OUT remains high. When the output signal has changed state (it is then at the low level), the input voltage V_{IN} must once again drop below the switching threshold V- to cause a new switching of the output signal.

In CMOS circuits on a bulk substrate, the potential of each node at a given instant is independent of the previous instants during which the circuit was in operation. This is not the case for silicon on insulator (SOI) circuits for which the behaviour of the circuit depends on the history of signals. Transistors on this substrate have an internal zone with a floating potential that is not immediately fixed by external polarisations and needs consequently some time to reach an equilibrium potential. This zone is called the floating substrate (body) and the dependence of the substrate potential on the history of signals is called the history effect.

Due to this history effect, the static transfer characteristic of the conventional Schmitt trigger circuit has a highly variable and uncontrollable hysteresis when it is used in the SOI technology. This undesirable fluctuation of the static transfer characteristic of the said conventional Schmitt trigger induces a fluctuation of dynamic characteristics, and particularly variation of the propagation time through the said circuit.

Therefore, the conventional Schmitt trigger circuit cannot be used without modification for applications on SOI. Thus, there is a need to adapt this circuit to Partially Depleted Silicon On Insulator (PD SOI) applications.

Document US 6.441.663 presents a Schmitt trigger CMOS circuit on SOI that overcomes this need by using Field Effect Transistors (FET) with substrate connectors. This document shows that the conventional electrical circuit for a Schmitt trigger remains applicable in an SOI technology, and special attention is paid to the manner in which the substrate connectors of the transistors are made.

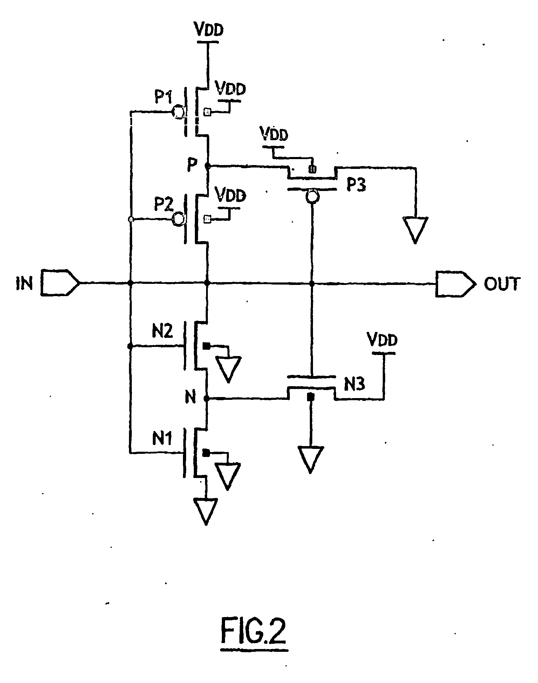

This type of circuit is shown in Figure 2. This scheme includes three N-channel junction field effect transistors (NFET) and three P-channel junction field effect transistors (PFET) for which the substrates are fixed to the power supply potentials. This is achieved by connecting the substrate connectors of PFET transistors to the power supply voltage, while the substrate connectors of NFET transistors are connected to the ground. The threshold voltages of transistors are thus fixed in time, independently of the input signal and its history, which overcomes the history effect problem but slows down the device.

Due to its operating principle, and as will be described later, this trigger is much less efficient when the power supply voltage is approximately equal to the value of the transistor threshold voltage. Consequently, use of this circuit is limited due to its degraded operation at a low power supply voltage, which takes place at the detriment of the speed and / or the silicon surface area.

Therefore, the purpose of the invention is to be able to use a Schmitt trigger circuit that takes advantage of the SOI technology and is effective particularly at a low power supply voltage.

It has been proposed to control the body potential of a FET transistor so as to modify its threshold voltage.

Document US 6,239,649 describes a SOI device wherein the body potential of a FET transistor is controlled by a signal upstream from said transistor on the input side. Such a control implies a fall of the threshold voltage at the time of the transistor commutation and a rise in the contrary case. However, in particular as the threshold voltage is not modified after commutation, such a control does not make it possible to introduce a hysteresis effect.

Document US 5,608,344 proposes an analog comparator circuit with hysteresis comprising in particular an input stage made up of a differential pair of P-channel FET transistors to the bodies of which are applied fixed continuous potentials, by means of switches ordered dynamically. This circuit does not take into account the constraints of the SOI technology (in particular history effect). Moreover this circuit does not propose to control the bodies of the N-channel and P-channel complementary FET transistors of a CMOS inverter stage carrying out a hysteresis effect.

The invention proposes a trigger circuit with hysteresis using the SOI technology, characterized in that it comprises at least two CMOS inverter stages, each inverter stage being composed of a first branch comprising at least one P-channel junction field effect transistor (PFET) in series between a first power supply potential V_{DD} and an output node from the inverter stage, and a second branch comprising at least one. N-channel junction field effect transistor (NFET) in series between the said output node from the inverter stage and a second power supply potential, the said transistors of each inverter stage having their grids connected together to receive an input signal. The input to each of the inverters directly or indirectly receives the input signal of the said circuit, while the output signal from the said circuit is obtained directly or indirectly from the output signal from one of the inverter stages. Finally, the substrate potential of each transistor of at least one inverter stage (advantageously the first inverter stage) is dynamically controlled by a control signal output from the said circuit.

The structure of the circuit as a succession of inverter stages in series between the input to the said circuit and its output, and the dynamic modification of the threshold voltage of the transistors of at least one inverter stage enable introduction of hysteresis effect based on acceleration of transistor blocking (in fact the PFET transistor(s) of the main inverter of the circuit according to the invention for a positive variation of the input voltage) rather than on delaying the starting conduction of transistor(s) (in fact the NFET transistor(s) of the main inverter of the circuit according to prior art for a positive variation of the input voltage). The invention can thus provide an "improvement" (by introducing an acceleration) where the circuit according to prior art caused a "degradation" (by introducing a deceleration) to introduce an unbalance of the V₋ and V₊ threshold voltages. Thus, the circuit according to the invention has higher performance characteristics than the circuit according to prior art. For equivalent immunity to noise, the merit factor (taking account of the speed, total consumption and the silicon area) of the invention is better than the merit factor for prior art for a wide range of power supply voltages.

According to a first embodiment of the invention, the substrate potentials of PFET and NFET transistors of at least one inverter stage, called the controlled inverter stage, are controlled by the same control signal. Advantageously, the substrate potentials of the PFET and NFET transistors of the controlled inverter stage are controlled by a signal determined by a state of the circuit on the output side of the said controlled inverter stage. The said substrate potentials of the PFET and NFET transistors of the controlled inverter stage can consequently be controlled by the output signal from an inverter stage, called the control inverter stage located downstream on the output side of the said controlled inverter stage. The control inverter stage is preferably separated from the controlled inverter stage by an even number of inverter stages in series between the said controlled inverter stage and the said control inverter stage. Advantageously, the said control inverter stage is the inverter stage immediately on the output-side of the said controlled inverter stage, and the even number of inverter stages then being equal to zero.

According to a second embodiment of the invention, the substrate potentials of the PFET transistors of at least one controlled inverter stage are controlled by a first control signal and the substrate potentials of the NFET transistors complementary to the said PFET transistors are controlled by a second control signal. Advantageously, the first control signal is a signal determined by a first state of the circuit on the output side of the said controlled inverter stage and the second control signal is a signal determined by a second state of the circuit located on the output side of the said controlled inverter stage. The signal determined by the said first state of the circuit can consequently be the output signal from a first inverter stage, called the first control inverter stage, located on the output side of the said controlled inverter stage, and the signal determined by the said second circuit state may be the signal from a second inverter stage, called the second controlled inverter stage, also located on the output side of the said controlled inverter stage. The said first control inverter stage is preferably separated from the said controlled inverter stage by a first even number (or zero) of inverter stages in series between the said controlled inverter stage and the said first control stage. Similarly, the said second control inverter stage is preferably separated from the said controlled inverter stage by a second even number (or zero) of inverter stages in series between the said controlled inverter stage and the said second control stage.

According to a third embodiment of the invention, the substrate potentials of the PFET transistors of at least one controlled inverter stage and the substrate potentials of the NFET transistors complementary to the said PFET transistors are all controlled by control signals that are different for each. Advantageously, each of the control signals is a signal determined by a state of the circuit on the output side of the said controlled inverter stage and this signal determined by a state of the circuit may be the output signal from an inverter stage called the control inverter stage, located on the output side of the said controlled inverter stage. Each control inverter stage is preferably separated from the said controlled inverter stage by an even number (or zero) of inverter stages in series between the said controlled inverter stage and the said control stage.

Advantageously, only the substrate potentials (or bodies) of the transistors in the first inverter stage are controlled, the substrate potentials of the inverter stage transistors other than the first inverter stage not being controlled and consequently being left floating.

Alternately, the substrate potentials of transistors in the first inverter stage are not the only potentials to be dynamically controlled. Substrate potentials of transistors other than the first stage can also be either connected conventionally to the power supply for PFETs or to the ground for NFETs, or they can be dynamically controlled by a state of the circuit on the output side and more particularly by the output signal from an inverter stage located on the output side. Advantageously, the different inverter stages are chained in sequence to operate in a "nested" manner, the substrate potentials of the transistors in an inverter stage other than the last inverter stage being controlled by the output signal from the inverter stage located directly on the output side and the substrate potentials of the transistors in the last inverter stage being either floating, or fixed to a power supply voltage.

According to the preferred embodiment of the invention, the circuit according to the invention comprises three inverter stages. The first two inverter stages are chained in series such that the output signal from the first inverter is applied to the input of the second inverter. The second and third inverter stages are also chained in series such that the output signal from the second inverter is applied to the input of the third inverter and to the substrates of the transistors in the first inverter stage.

The threshold trigger circuit according to the invention advantageously performs a Schmitt Trigger function.

Other characteristics, purposes and advantages of the invention will become clear after reading the following detailed description with reference to the appended drawings given as non-limitative examples, on which:
- figure 1 shows a conventional symmetric implementation of a Schmitt trigger circuit;
- figure 2 shows a Schmitt trigger circuit adapted to the conventional circuit in Figure 1 to be used in SOI and for which the substrate potentials of all transistors are fixed so that they are not left floating;
- figure 3a diagrammatically shows the Schmitt trigger circuit according to the invention;
- figure 3b more precisely shows the Schmitt trigger circuit according to the preferred embodiment of the invention;
- figure 4 shows a very simplified illustration of how the circuit according .to the preferred embodiment of the invention operates, and shows time diagrams for the different circuit signals during a transition of the input signal IN from the low state to the high state;
- figure 5 illustrates the fact that the transistor threshold voltages forming the core of the trigger function according to prior art as illustrated in Figure 2, are always greater than the threshold voltages of transistors forming the core of the trigger function according to the invention;
- figure 6 shows an elementary embodiment of the circuit according to the invention;
- figure 7 shows a more complex implementation of the circuit according to the invention, with dissociated control of substrate potentials of NFET and PFET transistors in the core of the trigger function, jointly with nesting of successive inverter stages;
- figure 8 shows another embodiment of the circuit according to the invention, with separate controls for PFET transistors in the same inverter stage, together with separate controls for NFET transistors of the same inverter stage.

Figure 1 shows a conventional symmetric embodiment of the CMOS Schmitt trigger circuit on a solid substrate. This well known circuit comprises three P-channel junction field effect transistors (PFET) P1, P2 and P3, and three N-channel junction field effect transistors (NFET) N1, N2 and N3. As mentioned above, transistors N2 and P2 form the main inverter of the Schmitt trigger, while the two assemblies composed firstly of transistors N1 and N3 and secondly of transistors P1 and P3 form two retroaction networks. Each of these retroaction networks fixes one threshold, and when combined the two thresholds thus obtained induce a hysteresis effect. Thus, as long as the input voltage V_{IN} has not reached the trigger threshold V₊ during a positive variation, the output signal OUT remains high. When the output signal OUT has changed state (it is now at low level), the input voltage V_{IN} must drop below the switching threshold V- during a negative variation, to cause a new switching. Therefore finally, depending on the direction of the variation of the input voltage V_{IN}, the Schmitt trigger is switched at different values of the said input voltage V_{IN}.

In this circuit, unchanged for applications in SOI technology, the substrate potentials of field effect transistors are all left floating. Since transistor substrate potentials, and therefore transistors threshold voltages, depend on the history of the input signal, the static characteristic of the circuit in Figure 1 on SOI has a variable hysteresis, in an undesirable and uncontrollable manner.

Therefore, there is a need for a Schmitt trigger circuit that does not have the disadvantages mentioned above when used for silicon on insulator (SOI) applications.

The circuit presented in document US 6.441.663 consists of an adaptation of the conventional integrated circuit on a solid substrate. This document shows that the scheme for the conventional Schmitt trigger circuit is valid in SOI technology if special attention is paid to the manner of contacting transistor substrates. Substrate potentials (bodies) must not be free to float to overcome the history effect.

This type of circuit is shown in Figure 2. The only difference between this circuit and the conventional Schmitt trigger circuit illustrated in Figure 1 is that all substrate potentials of all transistors in the circuit are fixed so that they are not floating. Substrate connectors of P-channel junction field effect transistors (P1, P2, P3) are connected to the power supply voltage for this purpose, while substrate connectors of N-channel junction field effect transistors (N1, N2, N3) are connected to the ground. In the context of this application of the conventional circuit to applications on SOI, substrate potentials are all imposed at fixed voltages and consequently threshold voltages are fixed in time, independently of the input signal and its history, which overcomes the history effect problem.

The functioning principle of the circuit according to prior art in Figure 2 is as follows. When the input signal IN of the circuit is in the low state and the output circuit OUT of the circuit is in the high stage, the transistor N3 is conducting, thus precharging the source of transistor N2 to a threshold voltage Vₜₕ under the power supply (node N).

When there is a transition on the input voltage V_{IN} from 0 to V_{DD}, the said input voltage of circuit V_{IN} must become sufficiently high so that the transistor N1 draws the source of N2 towards the ground more strongly than N3 draws it towards the power supply V_{DD}. Operation is symmetric for a transition of the input voltage V_{IN} from V_{DD} to 0, thus providing a hysteresis effect.

The hysteresis effect introduced during a transition from 0 to V_{DD} on the input is thus based on the delay in starting conduction of transistor N2.

Due to its operating principle, it can be seen that this trigger is much less efficient when the power supply voltage approaches the value of the threshold voltage Vₜₕ of the transistors, since the precharging transistors N3 and P3 then no longer perform their role satisfactorily. Consequently, use of this circuit is limited due to its degraded operation at low power supply voltage (which can be improved with a larger surface area of silicon).

As was mentioned above, the purpose of the invention is to obtain a Schmitt trigger circuit taking the best advantage of the SOI technology and particularly efficient at a low power supply voltage.

The Schmitt trigger circuit according to the invention comprises at least two chained CMOS inverter stages. The input signal to the IN circuit is applied to the input of the first inverter stage.

Each inverter stage comprises an upper branch in which there is at least one P-channel, junction field effect transistor (PFET) in series between a power supply voltage V_{DD} and an output node from the inverter stage, and a lower branch in which there is at least one N-channel junction field effect transistor (NFET) in series between the said output node from the inverter stage and a reference ground. The grids (or control electrodes) of these transistors are connected together and form the input to the inverter stage.

The output node from one of the two inverter stages directly or indirectly provides the output signal OUT from the circuit.

The substrate potentials of the transistors forming the first inverter stage are controlled dynamically. The said first inverter stage is then called the controlled inverter stage. Consequently, each substrate potential of the transistors forming the first inverter stage can thus be controlled dynamically by its own control signal.

Advantageously, the substrate potentials of the PFET transistors of the first inverter stage are all dynamically controlled by a first control signal, and the substrate potentials of the NFET transistors of the first inverter stage are all dynamically controlled by a second control signal, the first and second control signals of the substrate potentials of the PFET and NFET transistors being different. Optionally, the substrate potentials of the PFET and NFET transistors can be controlled by control signals corresponding to output signals from two different inverter stages and other than the first inverter stage. These inverter stages, for which the output signals control substrate potentials of the transistors in the controlled inverter stage, are called control inverter stages.

Alternatively, the control signal for substrates of PFET transistors and the control signal for substrate potentials of NFET transistors are identical and correspond to the output signal from an inverter stage (called the control inverter stage) other than the first inverter stage.

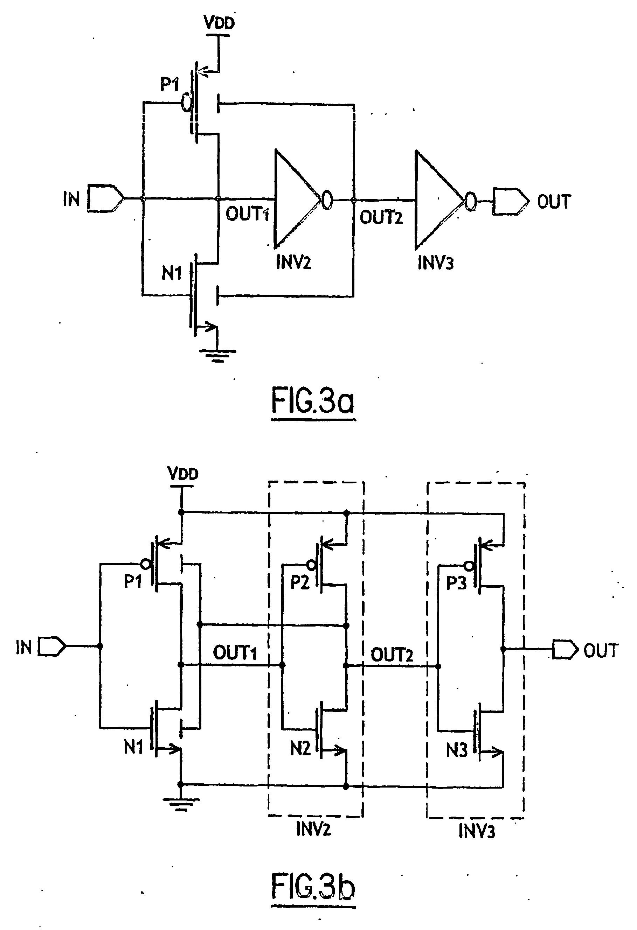

Figure 3a diagrammatically shows the Schmitt trigger circuit according to the invention. This circuit is composed of three chained inverter stages. The first inverter stage is composed of the P-channel junction field effect transistor (PFET) P1 and the N-channel junction field effect transistor (NFET) N1. This pair (P1, N1) of complementary transistors is in series between the power supply voltage V_{DD} and the reference ground. The junction of complementary transistors (P1, N1) is made at their drains that are connected together. The said junction thus forms the output node from the first inverter stage. The second and third inverter stages are composed of the conventional CMOS inverters INV₂ and INV₃ respectively. The input signal IN of the Schmitt trigger circuit is applied to the input of the first inverter. The output signal from the first inverter stage is called OUT1. The output signal from the second inverter stage is called OUT2. The output signal OUT from this Schmitt trigger circuit corresponds to the output from the third inverter stage INV₃.

The three inverter stages are chained as follows. The output signal OUT1 from the first inverter stage is applied to the input of the second inverter stage INV₂, while the output signal OUT2 from the second inverter stage INV₂ is applied to the input of the said third inverter stage INV₃.

In this preferred embodiment of the invention, the substrate potentials of the transistors in the pair of complementary transistors in the first inverter stage (P1, N1) are connected together and are both controlled by the output voltage V_{OUT2} from the second inverter stage INV₂. The first inverter stage is thus a controlled inverter stage and the second inverter stage is a control inverter stage.

Figure 3b shows the Schmitt trigger circuit according to the preferred embodiment of the invention more precisely, and particularly the composition of the second and third inverter stages INV₂ and INV₃. The second inverter stage INV₂ is composed of transistors P2 (PFET transistor) and N2 (NFET transistor) in series between the power supply voltage V_{DD} and the reference ground, and similarly the third inverter stage of transistors P3 (PFET transistor) and N3 (NFET transistor) in series between the power supply voltage V_{DD} and the reference ground.

Each inverter stage INVi is formed by the pair of complementary transistors (Pi, Ni). The junction of complementary transistors (Pi, Ni) is made at their drains that are connected together. The said junction thus forms the output node from each of the inverter stages INVi.

In this preferred embodiment of the invention, the substrate potentials of transistors forming inverter stages other than the first inverter stage are not controlled, unlike the transistors in the first inverter stage; therefore they are left floating.

We will now describe operation of the circuit according to the invention with reference to the circuit according to the preferred embodiment of the invention illustrated in Figure 3b. The core of the Schmitt trigger function is located at the first inverter stage, composed of transistors N1 and P1 for which the substrate potentials are dynamically controlled. The second inverter stage, for which the output voltage V_{OUT2} controls substrate potentials of the first inverter stage, forms the trigger control. The third and last inverter stage is used to shape the signal and to keep the globally inverting function. This provides a means of making a direct comparison with the Schmitt trigger circuit according to prior art illustrated in Figure 2.

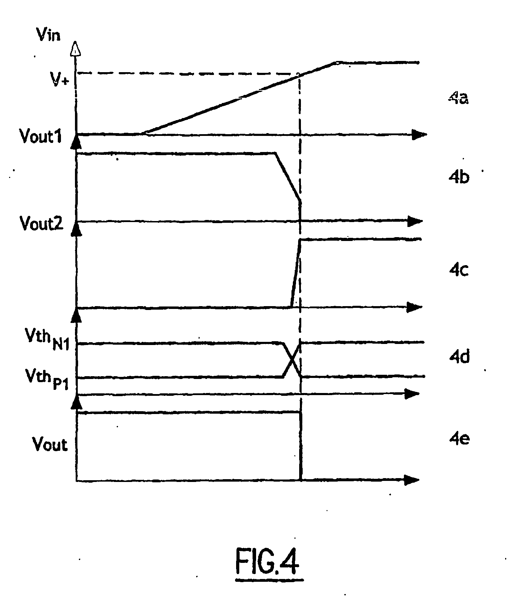

Figure 4 shows a simplified view of how.the circuit according to .the preferred embodiment of the invention functions during a transition of the circuit input voltage V_{IN} from 0 to V_{DD} including the time diagrams for the different signals. Time diagram 4a shows the transition of the input voltage V_{IN} from potential 0 to potential V_{DD}. Time diagrams 4b and 4c show the output voltages V_{OUT1} and V_{OUT2} of the first and second inverter stages respectively. Time diagram 4d illustrates absolute values of threshold voltages V_{thN1} and V_{thP1} of transistors N1 and P1 and their switching when the output voltage V_{OUT2} of the second inverter stage switches. Finally, time diagram 4e shows the behaviour of the output voltage V_{OUT} of the/ Schmitt trigger circuit in response to the transition of the input voltage V_{IN} from 0 to V_{DD}.

As can be seen in Figures 4b and 4c, when the input voltage V_{IN} to the circuit is 0, the output voltage V_{OUT1} from the first inverter is equal to V_{DD} and the output voltage V_{OUT2} from the second inverter is equal to 0.

As mentioned above, substrate potentials of transistors N1 and P1 in the first inverter stage are controlled by the output voltage V_{OUT2} from the second inverter. Since V_{OUT2} is equal to 0, the substrate potential of the transistor N1 is equal to 0 and the substrate potential of transistor P1 is also equal to 0.

Since the substrate potential of N1 is equal to zero, the substrate-source polarization voltage V_{BS N1} of transistor N1 is also equal to zero. The threshold voltage V_{thN1} of the said transistor N1 is thus a maximum over the normal variation range of the voltage V_{OUT2}, in other words [0; V_{DD}]. Note also that the said threshold voltage V_{thN1} could be even greater if the said substrate-source polarization voltage V_{BS N1} of transistor N1 becomes negative, in other words if the voltage V_{OUT2} becomes negative.

Similarly, the substrate potential of transistor P1 being controlled by a zero potential, consequently the substrate-source polarization voltage V_{BS P1} is equal to - V_{DD}. The absolute value of the threshold voltage V_{thP1} of the said transistor P1 is thus minimized. Consequently, by controlling the substrates in the first inverter stage by the output voltage V_{OUT2} from the second inverter stage, an unbalance of the absolute values of the threshold voltages of the complementary transistors N1 and P1 in the first inverter stage can be obtained. This unbalance is illustrated in Figure 4d.

As long as the circuit input voltage V_{IN} has not reached the switching threshold V₊, the output voltage from the first inverter stage V_{OUT1} remains high. As soon as the circuit input voltage V_{IN} reaches and exceeds the said switching threshold V₊, the output voltage from the first inverter stage V_{OUT1} changes to the low level and the first inverter stage switches as is illustrated in time diagrams 4a and 4b. Consequently, taking account of propagation times, the circuit output voltage V_{OUT} also changes to the low level and the circuit according to the invention switches.

Due to the unbalance of absolute values .of threshold voltages V_{thN1} and V_{thP1}, the said switching threshold V₊ is greater than the switching threshold V_{TO} that would have been necessary for the transistors to switch if the substrate connectors were connected to their respective sources, in other words if the substrate potentials were not dynamically controlled.

The value of the voltage V_{TO} also depends on the size of transistors N1 and P1. In general, the said transistors N1 and P1 are sized such that the switching threshold V_{TO} is equal to V_{DD}/2. Otherwise, propagation times of the rising and falling fronts would be asymmetric, and the cyclic pitch of treated signals would not be kept as they pass through the circuit.

The geometry of transistors N2 and P2 in the second inverter stage (in other words the control inverter) and particularly their width to length ratios, enables taking action on the amplitude of the hysteresis effect and even adjusting the two switching thresholds independently.

When there is a transition of the circuit input voltage V_{IN} from 0 to V_{DD}, the threshold voltage V_{thN1} of transistor N1 is greater than the absolute value of the threshold voltage Vₜₕₚ₁ of transistor P1. The output voltage V_{OUT1} from the first inverter stage changes to zero when the circuit input voltage V_{IN} reaches the said switching threshold V₊.

The output voltage V_{OUT2} from the second inverter stage INV₂ then switches to V_{DD} with a slight delay after switching of the output voltage V_{OUT1} of the first inverter stage. Since the substrates of transistors N1 and P1 were connected to V_{OUT2}, switching of V_{OUT2} then inverts the unbalance of the threshold voltages of transistors N1 and P1. The substrate potential of V1 is then equal to V_{DD}, consequently the substrate-source polarization voltage V_{BS N1} of transistor N1 is equal to V_{DD}. The value of the threshold voltage V_{thN1} of transistor N1 is thus minimized. Similarly, since the substrate potential of transistor P1 is equal to V_{DD}, the substrate-source polarization voltage V_{BS P1} is equal to 0. The absolute value of the threshold voltage V_{thP1} of the said transistor P1 is thus maximized.

Finally, in response to switching of the output signal OUT2 of the second inverter stage, in other words switching of the input signal to the third inverter stage, the output signal OUT from the third inverter stage, which is also the circuit output signal, changes from the high state to the low state.

Operation of this circuit is symmetric for a transition of the circuit input voltage V_{IN} from potential V_{DD} to potential 0.

When the circuit input voltage V_{IN} is equal to V_{DD}, the output voltage V_{OUT1} from the first inverter stage is equal to 0 and the output voltage V_{OUT2} from the second inverter stage is equal to V_{DD}. The substrate potentials of transistors N1 and P1 are then equal to V_{DD}. The substrate-source polarization voltage V_{BS N1} of transistor N1 is thus equal to V_{DD} and the value of the threshold voltage V_{thN1} of the said transistor N1 is therefore minimized. The substrate-source polarisation voltage V_{BS P1} is equal to 0 and therefore the absolute value of the threshold voltage V_{thP1} of the said transistor P1 is maximized.

The first inverter stage is then switched when the circuit input voltage V_{IN} reaches the switching threshold V.

The said switching threshold V- is less than the switching threshold V_{TO} that would have been necessary to observe switching of the transistors if the substrate connectors had been connected to their corresponding sources. In this case, remember that there would have been no hysteresis effect and that switching of the circuit input voltage V_{IN} would not have taken place unless V_{IN} had reached the switching threshold V_{TO}, regardless of its direction of variation.

The output signal OUT2 from the second inverter stage then switches to 0 with a slight delay on switching of the output signal OUT1 from the first inverter stage. Switching of OUT2 then inverts the unbalance of absolute values of threshold voltages V_{thN1} and Vₜₕₚ₁ of transistors N1 and P1. Finally, in response to switching of the output signal OUT2 of the second inverter stage, in other words switching of the input signal to the third inverter stage, the output signal OUT of the third inverter stage, which is also the circuit output signal, changes from the low state to the high state.

As mentioned above, when OUT2 switches, the direction of the inequality between the absolute values of voltage thresholds V_{thN1} and V_{thP1} of transistors N1 and P1 changes. Transconductance of complementary transistors N1 and P1 of the first inverter stage is then modified. This modification introduces a break in the fall of the voltage V_{OUT1}. The front of V_{OUT1} then becomes steeper during switching due to the drop in the absolute value of the threshold voltage of the transistor that starts conducting again (when V_{IN} goes up, N1 starts conducting and V_{thN1} drops; conversely, when V_{IN} drops, P1 starts conducting and the absolute value of V_{thP1} goes down). However, this break is only observable if elementary propagation times of inverters are negligible compared with the rise time of signal V_{IN}. And the second and third inverter stages strongly reduce this break due to their high voltage gains.

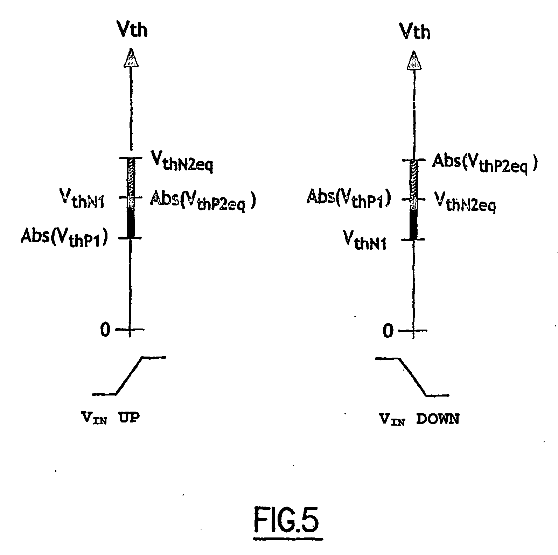

Therefore the Schmitt trigger according to the invention is distinct from prior art particularly due to the manner in which the hysteresis phenomenon is introduced. Figure 5 illustrates the fact that absolute values of voltage thresholds Vₜₕ of transistors at the heart of the trigger function are always lower in the context of the invention than according to prior art. The core of the trigger function in the context of the invention is the pair of transistors (N1; P1) (see Figures 3a and 3b) while according to prior art, the core of the trigger function is the pair of transistors (N2; P2) (see Figure 2).

During operation of the trigger circuit according to prior art, the effective threshold voltages of transistors N2 and P2 are the equivalent threshold voltages V_{thN2eq} and V_{thP2eq}. The said equivalent threshold voltages V_{thN2eq} and V_{thP2eq} are effectively different from the genuine threshold voltages V_{thN2} and V_{thP2} of transistors N2 and P2 respectively, since they are modified by the retroaction networks described above. And the absolute values of the said equivalent threshold voltages V_{thN2eq} and V_{thP2eq} are greater than the genuine threshold voltages due to the said retroaction networks, which demand a larger proportion of the energy from the circuit input generator and delay the moment at which the transistor starts conducting.

The diagram on the left in Figure 5 illustrates the case in which the circuit input voltage V_{IN} increases. In the context of the invention, the threshold voltage V_{thN1} of the transistor N1 is then greater than the absolute value of the threshold voltage V_{thP1} of the transistor P2. In the context of prior art, the equivalent threshold voltage V_{thN2eq} of transistor N2 is then greater than the absolute value of the equivalent threshold voltage V_{thP2eq} of transistor P2. And the threshold voltages [V_{thN1}, abs(V_{thP1})] of the transistors used in the trigger function according to the invention are less than the threshold voltages [V_{thN2eq}, abs (V_{thP2eq})] of the trigger function according to prior art, which is why the invention functions more quickly. Conversely, the diagram at the right of Figure 5 illustrates the case in which the circuit input voltage V_{IN} reduces. In the context of the invention, the absolute value of the threshold voltage V_{thP1} of transistor P1 is then greater than the value of the threshold voltage V_{thN1} of transistor N1. In prior art, the absolute value of the equivalent threshold voltage V_{thP2eq} of transistor . P2 is then greater than the value of the equivalent voltage threshold V_{thN2eq} of transistor N2. And the threshold voltages [abs(V_{thP1}, V_{thN1}] of transistors of the trigger function according to the invention are less than the threshold voltages [abs (V_{thP2eq}, V_{thN2eq}] of the trigger function according to prior art, which is why the invention functions more quickly.

After reading the above description, it can be understood that the operating principle of the Schmitt trigger circuit according to the invention consists of dynamically controlling the substrate potential of the complementary transistors. As a result, the absolute value of the threshold voltage of the conducting transistor is lowered before input switching occurs, and then the said absolute value of the said threshold voltage is restored to its nominal value and the absolute value of the threshold voltage of the other complementary transistor is lowered, in preparation for another switching in the inverse direction. As described above, the reduction in the absolute value of the threshold voltage of the transistors is made by increasing the absolute value of their substrate-source polarisation voltage V_{BS}.

The static and dynamic characteristics of the circuit according to the invention have been compared with the corresponding characteristics of a circuit according to prior art. It is found that the circuit according to the invention performs better than the circuit according to prior art. Thus, for equivalent immunity to noise, and for an entire range of power supply voltages, the merit factor (taking account of the speed, total consumption and silicon surface area) of the invention is better than the merit factor for prior art.

It will easily be understood, particularly with reference to the description of operation of the circuit according to the preferred embodiment of the invention given above, that a circuit composed of two inverter stages and for which the substrate potentials of the transistors in the first inverter stage are controlled by the output signal from the second inverter stage also performs the required function, except for one inversion, while taking full advantage of the SOI technology.

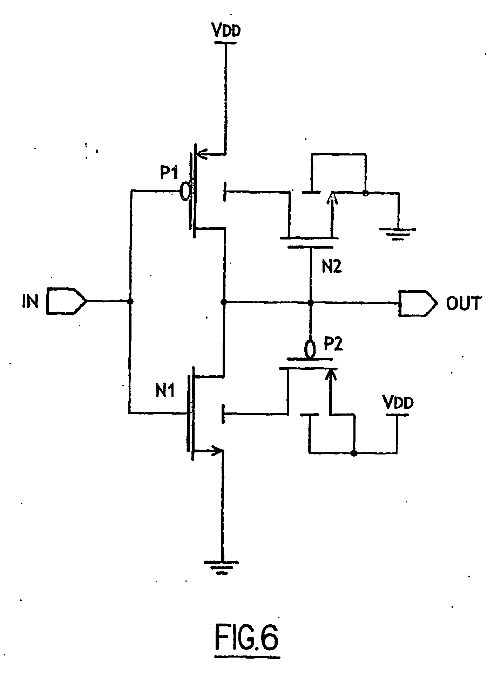

Figure 6 illustrates another embodiment of the inverter circuit with hysteresis according to the invention. This scheme shows an elementary embodiment of the invention in which the circuit layout is similar to prior art illustrated in Figure 2. This elementary embodiment advantageously comprises only four transistors.

The core of the trigger function is composed of transistors P1 (PFET transistor) and N1 (NFET transistor) in series between the power supply voltage V_{DD} and the reference ground.

The grids of transistors P1 and N1 are connected together to receive the circuit input signal IN while the drains of transistors P1 and N1 are connected together to form the circuit output signal OUT.

The said output signal OUT from the circuit is also applied to the grids of the two transistors P2 (PFET transistor) and N2 (NFET transistor). Transistors P2 and N2 perform the dynamic control function for substrate potentials of transistors P1 and N1.

The substrate potential of transistor P1 is dynamically controlled by the signal at the drain of the said transistor N2 and the substrate potential of transistor N1 is dynamically controlled by the signal at the drain of the said transistor P2. The source and substrate connector of transistor N2 are fixed to the ground, while the source and the substrate connector of transistor P2 are fixed to the power supply voltage V_{DD}.

Advantageously, the substrate connectors of transistors N1 and P1 may also be connected together and may share the same dynamic control.

Finally, it will be noted that the circuit according to the embodiment shown in Figure 6 comprises two CMOS inverters chained in series, for which the output from the second inverter controls the substrates of the transistors in the first inverter; the output from the circuit being given by the output of the first inverter, and not by the output from the second inverter.

Depending on the required objective for optimisation of the circuit according to the invention (immunity to noise, speed, consumption, compactness), the said circuit may be arranged in different variants. And the characteristics of the said variants may advantageously be taken alone or in any possible combination for making a trigger circuit with hysteresis according to the invention:
- The substrate potentials of PFET transistors of at least one controlled inverter stage, preferably the first, may be controlled by a first control signal and the substrate potentials of the complementary NFET transistors may be controlled by a second control signal, in other words control of substrate potentials of PFET transistors can advantageously be dissociated from control of substrate potentials of NFET transistors. Advantageously, the said first control signal is determined by a first state of the circuit on the output side of the said controlled inverter stage and the second control signal is determined by a second state of the circuit on the output side of the said controlled inverter stage. The signal determined by the said first state of the circuit can consequently be the output signal from a first inverter stage, called the first control inverter stage, located on the output side of the said controlled inverter stage and the signal determined by the said second state of the circuit can be the output signal from a second inverter stage called the second controlled inverter stage, also located on the output side of the said controlled inverter stage.

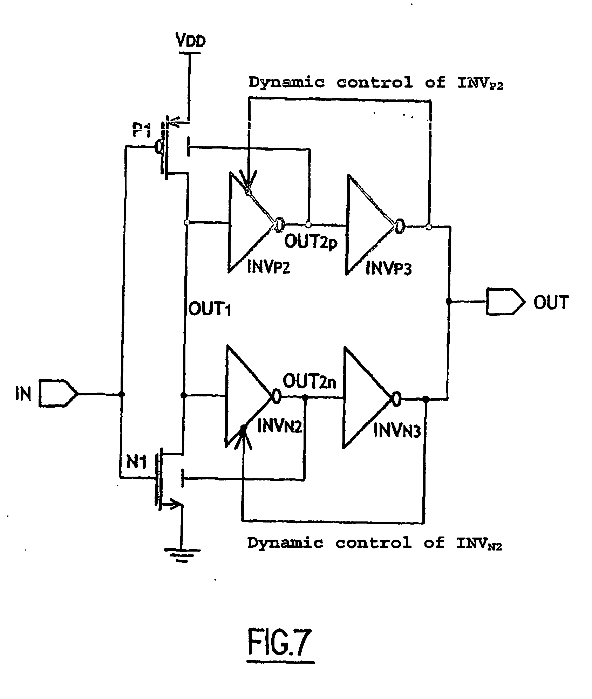

In particular, Figure 7 illustrates a similar case in which control of the substrate potentials of transistors N1 and P1 forming the first inverter stage is dissociated, The first inverter stage in this case is a controlled inverter stage. The substrate potential of transistor P1 is dynamically controlled by the output voltage V_{OUT2p} from a first control inverter stage INV_{P2}. The substrate potential of transistor N1 is dynamically controlled by the output voltage V_{OUT2n} from a second control inverter stage INV_{N2}.
- The substrate potentials of the PFET transistors of at least one controlled inverter stage, advantageously the first inverter stage, cannot all be controlled by the same control signal and similarly the substrate potentials of the complementary NFET transistors do not need to be controlled by the same control signal, in other words the controls of substrate potentials of PFET transistors can advantageously be dissociated from each other (and similarly controls of complementary NFET transistors can be dissociated). Advantageously, pairs of PFET and NFET transistors can be grouped together so that their substrate potentials can be controlled by the same control signal. For example, a first control signal controls the substrate potentials of some pairs of PFET and NFET transistors (the said first control signal being the signal determined by a first state of the circuit located on the output side of the said controlled inverter stage) and the second control signal controls substrate potentials of other pairs of PFET and NFET transistors (the second control signal being a signal determined by a second state of the circuit on the output side of the said controlled inverter stage). The signal determined by the said first state of the circuit can be an output signal from a first inverter stage called the control inverter stage, located on the output side of the said controlled inverter stage and the signal determined by the said second state of the circuit may be the output signal from a second inverter stage, called the second control inverter stage, also located on the output side of the said controlled inverter stage. Each control inverter stage is preferably separated from the said controlled inverter stage by an even number (or zero) of inverter stages in series between the said controlled inverter stage and the said control stage.

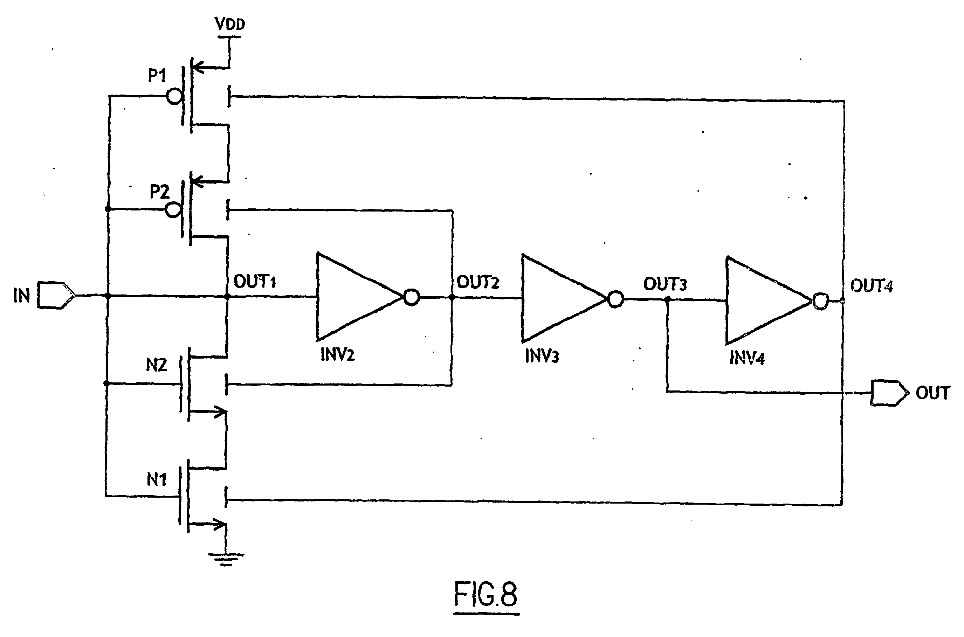

In this respect, Figure 8 shows a circuit according to the invention comprising four inverter stages and in which the first inverter stage called the controlled inverter stage is composed of an upper branch comprising two PFET transistors P1, P2 and a lower branch comprising two complementary NFET transistors N2, N1. The substrate potentials of transistors P2 and N2 included in a first group consisting of at least one pair of PFET and NFET transistors are dynamically controlled by the output voltage V_{OUT2} of the second inverter stage INV₂, called the control inverter stage. The substrate potentials of transistors P1 and N1 included in a second group of at least one pair of PFET and NFET transistors are dynamically controlled by the output voltage V_{OUT4} from a fourth inverter stage INV₄, called the control inverter stage. The control inverter stages INV₂ and INV₄ are each separated from the said controlled inverter stage by an even or zero number of inverter stages in series: the control inverter stage INV₂ is located immediately on the output side of the said controlled inverter stage (the number of inverter stages located between the said controlled inverter stage and INV₂ then being zero) and the control inverter stage INV₄ is separated from the controlled inverter stage by inverter stages INV₂ and INV₃ (the even number then being equal to two). Finally, note that the output OUT from the circuit is directly connected to the output OUT3 from the third inverter stage INV₃.
- Each inverter stage may be composed of a number of PFET and NFET transistors (not systematically the same number) in series between the first and second power supply potential. This provides a means of advantageously offsetting the transfer characteristic of the hysteresis circuit with respect to half the power supply voltage V_{DD}/2 which may be useful for specific applications. The simplest example in the context of this variant consists for example of putting two NFET and one PFET in series between the power supply and the ground to create an inverter stage.
- Each inverter stage may also be made using an odd number of elementary inverters chained in series.
- The substrate potentials of transistors in the first stage are not necessarily the only transistors to be dynamically controlled. The substrate potentials of transistors other than those in the first stage may thus be either left floating, or may be conventionally connected to the power supply voltage for PFETs or to the ground for NFETs, or they may be dynamically controlled by a state of the circuit on the output side and more particularly by the output signal from an inverter stage located on the output side. Advantageously, the circuit according to the invention comprises several inverter stages chained one after the other operating in a nested manner, so as to amplify the retroaction control. Consequently, substrate potentials of transistors in an inverter stage other than the last inverter stage are controlled by the output signal from the inverter stage located on the output side in the chain of inverters and the substrate potentials of transistors in the last inverter stage are either floating or are fixed to a power supply voltage.

Figure 7 illustrates this type of nesting of inverter stages, jointly with the characteristic of a control dissociated from the substrate connectors of the NFET and PFET transistors. Thus, the substrate potential of the PFET transistor P1 of the first inverter stage is controlled by the output voltage V_{OUT2p} of the inverter INV_{P2} and the substrate potential of transistors in inverter INV_{P2} is controlled by the output voltage V_{OUT} of the inverter INV_{P3}. Symmetrically, the substrate potential of the NFET transistor N1 of the first inverter stage is controlled by the output voltage V_{OUT2n} from the inverter INV_{N2} and the substrate potential of transistors in inverter INV_{N2} is controlled by the output voltage V_{OUT} of inverter INV_{N3}.

Obviously, the invention is not limited to the particular embodiments described above, but includes any trigger with hysteresis, inverter or not, complying with the claims. In particular, the invention does not apply solely to a trigger circuit with hysteresis, but includes any integrated circuit on a semiconductor on insulator substrate, particularly on an SOI substrate, comprising such a trigger circuit with hysteresis according to the claims.

## Claims

1. Trigger circuit with hysteresis using the semiconductor on insulator technology, **characterised in that** it comprises at least two CMOS inverter stages, each inverter stage being composed of a first branch comprising at least one P-channel junction field effect transistor (PFET) in series between a first power supply potential V_{DD} and an output node from the inverter stage, and a second branch comprising at least one N-channel junction field effect transistor (NFET) in series between the said output node from the inverter stage and a second power supply potential, the said transistors of each inverter stage having their grids connected together to receive an input signal, the input to each of the inverters directly or indirectly receiving the input signal of the said circuit, the output signal from the said circuit being obtained directly or indirectly by the output signal from one of the inverter stages, and **in that** the substrate potential of each transistor of at least one inverter stage called the controlled inverter stage, is dynamically controlled by a control signal output from the said circuit.

2. Circuit according to claim 1, **characterised in that** the control signals controlling the said substrate potentials for transistors PFET and NFET of at least one controlled inverter stage are signals determined by the states of the circuit located on the output side of the said controlled inverter stage.

3. Circuit according to the above claim, **characterised in that** the said signals determined by the states of the circuit located on the output side of the said controlled inverter stage are output signals from inverter stages called control inverter stages, located on the output side of the said controlled inverter stage.

4. Circuit according to the above claim, **characterised in that** the said control inverter stages are separated from the said controlled inverter stage by an even number (or zero) of inverter stages.

5. Circuit according to one of claims 1 to 4, **characterised in that** the substrate potentials for complementary transistors PFET and NFET of at least one controlled inverter stage are controlled by the same control signal.

6. Circuit according to one of claims 1 to 4, **characterised in that** the substrate potentials for PFET transistors of at least one controlled inverter stage are controlled by a first control signal and substrate potentials for NFET transistors complementary to the said PFET transistors are controlled by a second control signal.

7. Circuit according to one of claims 1 to 4, **characterised in that** the substrate potentials for PFET transistors of at least one controlled inverter stage and substrate potentials for NFET transistors complementary to the said PFET transistors are all controlled by different control signals.

8. Circuit according to one of claims 1 to 4, **characterised in that** the substrate potentials for transistors of at least one controlled inverter stage included in a group of at least one pair of complementary PFET and NFET transistors are controlled by the same control signal.

9. Circuit according to one of the above claims, **characterised in that** the substrate potential of transistors of the first inverter stage is controlled.

10. Circuit according to one of the above claims, **characterised in that** it includes three inverter stages.

11. Circuit according to the above claim, **characterised in that** the first two inverter stages are chained such that the output signal from the first inverter is applied to the input to the second inverter.

12. Circuit according to the above claim, **characterised in that** the second and third inverter stages are chained such that the output signal from the second inverter is applied to the input of the third inverter.

13. Circuit according to one of the above claims, **characterised in that** only the substrate potentials of transistors in the first stage are dynamically controlled, the substrate potentials for the transistors in inverter stages other than the first inverter stages not being controlled and being either left floating, or fixed to the power supply potentials of the circuit.

14. Circuit according to one of claims 1 to 12, **characterised in that** the substrate potentials for transistors in an inverter stage other than the last inverter stage are dynamically controlled by the output signal from the inverter stage located directly downstream on the output side, the substrate potentials for the transistors in the last inverter stage being either left floating, or fixed to the power supply potentials of the circuit.

15. Circuit according to one of the above claims, **characterised in that** the trigger circuit with hysteresis is a Schmitt Trigger circuit.

16. Circuit according to one of the above claims, **characterised in that** it is used in the SOI technology.

17. Circuit integrated on a semiconductor on insulator substrate, **characterised in that** it comprises at least one trigger circuit with hysteresis according to one of the above claims.

## Patentansprüche

1. Trägerschaltkreis bzw. Kippstufe mit Hysterese unter Verwendung der Halbleiter-auf-Isolator-Technologie, **dadurch gekennzeichnet, dass** er zumindest zwei CMOS-Invertorstufen aufweist, wobei jede Invertorstufe aus einem ersten Zweig, der zumindest einen P-Kanal Sperrschicht-Feldeffekt-Transistor (PFET) in Reihe geschaltet zwischen einem ersten Energieversorgungspotential V_{DD} und einem Ausgangsknoten der Invertorstufe aufweist, und einem zweiten Zweig, der zumindest einen N-Kanal Sperrschicht-Feldeffekt-Transistor (NFET) in Reihe zwischen dem besagten Ausgangsknoten der Invertorstufe und einem zweiten Energieversorgungspotential geschaltet aufweist, zusammengesetzt ist, wobei die Transistoren jeder Invertorstufe ihre Gitter zusammengeschlossen haben, um ein Eingangssignal zu empfangen, wobei der Eingang von jedem Invertor das Eingangssignal des Schaltkreises direkt order indirekt empfängt, wobei das Ausgangssignal von dem Schaltkreis direkt oder indirekt von dem Ausgangssignal von einer der Invertorstufen erhalten wird, und wobei das Substratpotential von jedem Transistor von zumindest einer Invertorstufe, genannt die gesteuerte Invertorstufe, dynamisch gesteuert wird durch ein Steuersignalausgang von dem Schaltkreis.

2. Schaltkreis nach Anspruch 1, **dadurch gekennzeichnet, dass** die Steuersignale, die die Substratpotentiale für die PFET- und NFET-Transistoren von zumindest einer gesteuerten Invertorstufe steuern, Signale sind, die durch die Zustände des Schaltkreises bestimmt werden, der an der Ausgangsseite der gesteuerten Invertorstufe lokalisiert ist.

3. Schaltkreis nach obigem Anspruch, **dadurch gekennzeichnet, dass** die Signale, die von den Zuständen des Schaltkreises bestimmt werden, der an der Ausgangsseite der gesteuerten Invertorstufe lokalisiert ist, Ausgangssignale von den Invertorstufen sind, die Steuerinvertorstufen genannt werden, die an der Ausgangsseite der gesteuerten Invertorstufe lokalisiert sind.

4. Schaltkreis nach einem der obigen Ansprüche, **dadurch gekennzeichnet, dass** die Steuerinvertorstufen von der gesteuerten Invertorstufe durch eine gerade Anzahl (oder Null) von Invertorstufen getrennt ist.

5. Schaltkreis nach einem der Ansprüche 1 bis 4, **dadurch gekennzeichnet, dass** die Substratpotentiale für komplementäre Transistoren PFET und NFET von zumindest einer gesteuerten Invertorstufe durch das gleiche Steuersignal gesteuert werden.

6. Schaltkreis nach einem der Ansprüche 1 bis 4, **dadurch gekennzeichnet, dass** die Substratpotentiale für PFET-Transistoren von zumindest einer gesteuerten Invertorstufe durch ein erstes Steuersignal gesteuert werden und die Substratpotentiale für die NFET-Transistoren, die komplementär zu den PFET-Transistoren sind, von einem zweiten Steuersignal gesteuert werden.

7. Schaltkreis nach einem der Ansprüche 1 bis 4, **dadurch gekennzeichnet, dass** die Substratpotentiale für PFET-Transistoren von zumindest einer gesteuerten Invertorstufe und die Substratpotentiale für NFET-Transistoren komplementär zu den PFET-Transistoren alle durch unterschiedliche Steuersignale gesteuert werden.

8. Schaltkreis nach einem der Ansprüche 1 bis 4, **dadurch gekennzeichnet, dass** die Substratpotentiale für Transistoren von zumindest einer gesteuerten Invertorstufe, die zu einer Gruppe aus zumindest einem Paar von komplementären PFET- und NFET-Transistoren gehören, durch das selbe Steuersignal gesteuert werden.

9. Schaltkreis nach einem der obigen Ansprüche, **dadurch gekennzeichnet, dass** das Substratpotential der Transistoren der ersten Invertorstufe gesteuert wird.

10. Schaltkreis nach einem der obigen Ansprüche, **dadurch gekennzeichnet, dass** er drei Invertorstufen beinhaltet.

11. Schaltkreis nach dem obigen Anspruch, **dadurch gekennzeichnet, dass** die ersten zwei Invertorstufen verkettet sind, so dass das Ausgangsignal von dem ersten Invertor an den Eingang des zweiten Invertors angelegt wird.

12. Schaltkreis nach dem obigen Anspruch, **dadurch gekennzeichnet, dass** die zweite und dritte Invertorstufe verkettet sind, so dass das Ausgangssignal von dem zweiten Invertor an den Eingang des dritten Invertors angelegt wird.

13. Schaltkreis nach einem der obigen Ansprüche, **dadurch gekennzeichnet, dass** nur die Substratpotentiale der Transistoren in der ersten Stufe dynamisch gesteuert werden, wobei die Substratpotentiale für die Transistoren in Invertorstufen außer der ersten Invertorstufe nicht gesteuert werden und entweder erdfrei gelassen werden oder an die Energiezuführungspotentiale des Schaltkreises angelegt werden.

14. Schaltkreis nach einem der Ansprüche 1 bis 12, **dadurch gekennzeichnet, dass** die Substratpotentiale für die Transistoren in einer Invertorstufe außer der letzten Invertorstufe dynamisch gesteuert werden durch das Ausgangssignal von der Invertorstufe, die direkt abstromig an der Ausgangsseite lokalisiert ist, wobei die Substratpotentiale für die Transistoren in der letzten Invertorstufe entweder erdfrei oder auf den Energiezuführungspotentialen des Schaltkreises liegen.

15. Schaltkreis nach einem der obigen Ansprüche, **dadurch gekennzeichnet, dass** der Triggerschaltkreis mit Hysterese ein Schmitt-Trigger-Schaltkreis ist.

16. Schaltkreis nach einem der obigen Ansprüche, **dadurch gekennzeichnet, dass** er in der SOI-Technologie verwendet wird.

17. Schaltkreis, der auf einem Halbleiter auf einem isolierenden Substrat integriert ist, **dadurch gekennzeichnet, dass** er zumindest einen Triggerschaltkreis mit Hysterese gemäß einem der obigen Ansprüche aufweist.

## Revendications

1. Circuit bascule à hystérésis en technologie semi-conducteur sur isolant, **caractérisé en ce qu'**il comprend au moins deux étages inverseurs CMOS, chaque étage inverseur étant constitué d'une première branche comprenant au moins un transistor à effet de champ à jonction canal P (PFET) en série entre un premier potentiel d'alimentation V_{DD} et un noeud de sortie de l'étage inverseur et d'une seconde branche comprenant au moins un transistor à effet de champ à jonction canal N (NFET) en série entre ledit noeud de sortie de l'étage inverseur et un second potentiel d'alimentation, lesdits transistors de chacun des étages inverseurs ayant leurs grilles connectées ensemble pour recevoir un signal d'entrée, l'entrée de chacun des inverseurs recevant directement ou indirectement le signal d'entrée dudit circuit, le signal de sortie du circuit étant obtenu directement ou indirectement par le signal de sortie de l'un des étages inverseurs, et **en ce que** le potentiel de substrat de chacun des transistors d'au moins un étage inverseur, dit étage inverseur piloté, est piloté dynamiquement par un signal de commande issu dudit circuit.

2. Circuit selon la revendication 1, **caractérisé en ce que** les signaux de commande pilotant lesdits potentiels de substrat des transistors PFET et NFET d'au moins un étage inverseur piloté sont des signaux déterminés par des états du circuit situé en aval dudit étage inverseur piloté.

3. Circuit selon la revendication précédente, **caractérisé en ce que** lesdits signaux déterminés par des états du circuit situé en aval dudit étage inverseur piloté sont les signaux de sortie d'étages inverseurs, dits étages inverseurs de commande, situés en aval dudit étage inverseur piloté.

4. Circuit selon la revendication précédente, **caractérisé en ce que** lesdits étages inverseurs de commande sont séparés dudit étage inverseur piloté par un nombre pair ou nul d'étages inverseurs.

5. Circuit selon l'une des revendications 1 à 4, **caractérisé en ce que** les potentiels de substrat des transistors complémentaires PFET et NFET d'au moins un étage inverseur piloté sont pilotés par un même signal de commande.

6. Circuit selon l'une des revendications 1 à 4, **caractérisé en ce que** les potentiels de substrat des transistors PFET d'au moins un étage inverseur piloté sont pilotés par un premier signal de commande et les potentiels de substrat des transistors NFET complémentaires desdits transistors PFET sont pilotés par un second signal de commande.

7. Circuit selon l'une des revendications 1 à 4, **caractérisé en ce que** les potentiels de substrat des transistors PFET d'au moins un étage inverseur piloté et les potentiels de substrat des transistors NFET complémentaires desdits transistors PFET sont tous pilotés par des signaux de commande différents.

8. Circuit selon l'une des revendications 1 à 4, **caractérisé en ce que** les potentiels de substrat des transistors d'au moins un étage inverseur piloté compris dans un regroupement d'au moins une paire de transistors complémentaires PFET et NFET sont pilotés par un même signal de commande.

9. Circuit selon l'une des revendications précédentes, **caractérisé en ce que** les transistors du premier étage inverseur ont leur potentiel de substrat piloté.

10. Circuit selon l'une des revendications précédentes, **caractérisé en ce qu'**il comprend trois étages inverseurs.

11. Circuit selon la revendication précédente, **caractérisé en ce que** les deux premiers étages inverseurs sont chaînés de telle sorte que le signal de sortie du premier inverseur est appliqué à l'entrée du deuxième inverseur.

12. Circuit selon la revendication précédente, **caractérisé en ce que** le deuxième et le troisième étages inverseurs sont chaînés de telle sorte que le signal de sortie du deuxième inverseur est appliqué à l'entrée du troisième inverseur.

13. Circuit selon l'une des revendications précédentes, **caractérisé en ce que** seuls les potentiels de substrat des transistors du premier étage inverseur sont pilotés dynamiquement, les potentiels de substrat des transistors des étages inverseurs autres que le premier étage inverseur n'étant pas pilotés et étant soit laissés flottants soit fixés aux potentiels d'alimentation du circuit.

14. Circuit selon l'une des revendications 1 à 12, **caractérisé en ce que** les potentiels de substrat des transistors d'un étage inverseur autre que le dernier étage inverseur sont pilotés dynamiquement par le signal de sortie de l'étage inverseur situé directement en aval, les potentiels de substrat des transistors du dernier étage inverseur étant soit laissés flottants soit fixés aux potentiels d'alimentation du circuit.

15. Circuit selon l'une des revendications précédentes, **caractérisé en ce que** le circuit bascule à hystérésis est un circuit Trigger de Schmitt.

16. Circuit selon l'une des revendications précédentes, **caractérisé en ce qu'**il est réalisé en technologie semi-conducteur sur isolant.

17. Circuit intégré sur substrat semi-conducteur sur isolant, **caractérisé en ce qu'**il comprend au moins un circuit bascule à hystérésis selon l'une des revendications précédentes.
